# EUROPÄISCHE PATENTANMELDUNG

(11) **EP 3 139 223 A1**
(43) Veröffentlichungstag der Anmeldung: **08.03.2017**
(21) Anmeldenummer: 16187057.1
(22) Anmeldetag: 02.09.2016
(51) Int. Cl.: G05B 19/042, H03K 17/94, H03K 17/945, H04N 5/232

(54) **SENSOREINRICHTUNG ZUR ÜBERWACHUNG EINES SENSORBEREICHS UND VERFAHREN ZUM UMSCHALTEN ZWISCHEN ZWEI BETRIEBSMODI**

(30) Priorität: 03.09.2015 DE 102015216898
(71) Anmelder: di-soric GMBH & CO. KG, 73660 Urbach (DE)
(72) Erfinder: LAUBISCH, Ralf, 57489 Drolshagen (DE); KORBMACHER, Stephan, 44388 Dortmund (DE)
(74) Vertreter: Maikowski & Ninnemann Patentanwälte Partnerschaft mbB

(57) **Zusammenfassung**

Die vorliegende Erfindung betrifft insbesondere eine Sensoreinrichtung (1) zur Überwachung eines Sensorbereichs, wobei über die Sensoreinrichtung (1) das Vorhandensein eines Objekts (2) in einem Sensorbereich und/oder die Abwesenheit eines Objekts (2) aus einem Sensorbereich als Detektionsereignis detektierbar ist, und wobei
- die Sensoreinrichtung (1) mindestens ein Bedienelement (13) aufweist, über das ein Schaltabstand und/oder eine Empfindlichkeit der Sensoreinrichtung (1) zwischen einem Minimalwert und einem Maximalwert einstellbar ist, und
- die Sensoreinrichtung (1) in wenigstens zwei unterschiedlichen Betriebsmodi betreibbar ist.

Erfindungsgemäß ist eine Steuerelektronik vorgesehen, über die ein Umschalten von einem Betriebsmodus in den wenigstens einen anderen Betriebsmodus über das Einstellen eines maximalen oder minimalen Schaltabstands und/oder einer maximalen oder minimalen Empfindlichkeit und die Auslösung eines Detektionsereignisses innerhalb eines über die Steuerelektronik der Sensoreinrichtung (1) vorgegebenen Zeitraums steuerbar ist.

Darüber hinaus ist ein Verfahren zum Umschalten zwischen zwei Betriebsmodi einer Sensoreinrichtung (1) vorgeschlagen, bei dem automatisch von einem Betriebsmodus in den wenigstens einen anderen Betriebsmodus umgeschaltet wird, wenn einerseits das Einstellen eines maximalen oder minimalen Schaltabstands und/oder einer maximalen oder minimalen Empfindlichkeit und andererseits das Auslösen eines Detektionsereignisses innerhalb eines vorgegebenen Zeitraums erfolgt.

## Beschreibung

Die Erfindung betrifft eine Sensoreinrichtung nach dem Oberbegriff des Anspruchs 1 sowie ein Verfahren zum Umschalten zwischen wenigstens zwei Betriebsmodi einer Sensoreinrichtung nach dem Anspruch 11.

Eine gattungsgemäße Sensoreinrichtung ist zur Überwachung eines Sensorbereichs ausgebildet und vorgesehen, wobei über die Sensoreinrichtung das Vorhandensein eines Objekts in dem Sensorbereich und/oder die Abwesenheit eines Objekts in dem Sensorbereich als Detektionsereignis detektierbar ist. Über die Sensoreinrichtung ist somit feststellbar, ob sich ein Objekt in dem Sensorbereich befindet, insbesondere ob ein Objekt in den Sensorbereich gelangt und/oder ob sich ein Objekt nicht mehr in dem Sensorbereich befindet, insbesondere ob sich ein Objekt aus dem Sensorbereich entfernt. Hierbei ist dann in Abhängigkeit von einem Detektionsereignis ein Sensorsignal erzeugbar. Beispielsweise umfasst eine solche Sensoreinrichtung einen kapazitiven Näherungsschalter, über den detektierbar ist, ob sich ein Objekt in einem kapazitiven überwachten Sensorbereich befindet und welchen Abstand es zu dem Näherungsschalter einnimmt. Hierüber können beispielsweise Funktionsabläufe an einer Werkzeugmaschine gesteuert werden.

Es ist bekannt, an derartigen Sensoreinrichtungen mindestens ein Bedienelement vorzusehen, über das ein Schaltabstand oder eine Empfindlichkeit der Sensoreinrichtung zwischen einem Minimalwert und einem Maximalwert einstellbar ist. Unter der Einstellung eines Schaltabstands wird hierbei insbesondere verstanden, dass bei einem Näherungsschalter dessen Reichweite einstellbar ist. Als Bedienelement kann zum Beispiel ein Potentiometer eingesetzt sein. Mit Veränderung eines Schaltabstands kann grundsätzlich je nach Typ der Sensoreinrichtung bekanntermaßen auch eine Empfindlichkeit der Sensoreinrichtung verändert werden. Es sind aber auch Sensoreinrichtungen, wie z.B. Lichtschranken, bekannt, bei denen eine Änderung der (Mess-) Empfindlichkeit nicht zwingend mit einer Änderung eines Schaltabstands einhergeht.

Ferner ist es bekannt, dass Sensoreinrichtungen in wenigstens zwei unterschiedlichen Betriebsmodi betreibbar sind, um zusätzliche Funktionen innerhalb der Sensoreinrichtung abzubilden. So ist es beispielsweise bekannt, über ein zusätzliches Bedienelement und/oder ein zusätzliches Schalterelement an der Sensoreinrichtung diese zwischen einem Öffnermodus und einem Schließermodus hin und her zu schalten, sodass ein Schaltausgang der Sensoreinrichtung wahlweise ein Sensorsignal erzeugt, wenn ein Objekt in dem überwachten Sensorbereich auftritt oder wenn sich ein Objekt aus dem überwachten Sensorbereich entfernt. Ein solches Umschalten zwischen unterschiedlichen Funktionen und damit Betriebsmodi erfordert dabei regelmäßig zusätzliche Tasten oder Schalter an einer Sensoreinrichtung. Dies ist jedoch unerwünscht, da derartige Sensoreinrichtungen in vergleichsweise kleinen Bauräumen untergebracht werden müssen und zudem zusätzliche Tasten oder Schalter mit vergleichsweise hohen zusätzlichen Mehrkosten verbunden sind.

Alternativ werden daher insbesondere bei Näherungsschaltern mit Potentiometer bisher regelmäßig unterschiedliche Varianten vorgehalten, die jeweils nur in genau einem Betriebsmodus betreibbar sind. So werden bisher üblicherweise zum Beispiel Näherungsschalter nur mit Öffnerfunktion oder nur mit Schließerfunktion vorgehalten, bei denen jeweils über ein Potentiometer ein Schaltabstand des Näherungsschalters einstellbar ist.

Es ist Aufgabe der Erfindung, bisher bekannte Sensoreinrichtungen in dieser Hinsicht zu verbessern und insbesondere eine Sensoreinrichtung bereitzustellen, die in wenigstens zwei unterschiedlichen Betriebsmodi betreibbar und zu vergleichsweise geringen Herstellungskosten produzierbar ist.

Diese Aufgabe wird sowohl mit einer Sensoreinrichtung des Anspruchs 1 als auch mit einem Verfahren des Anspruchs 11 gelöst.

Erfindungsgemäß ist hierbei eine Steuereinrichtung mit einer Steuerelektronik vorgeschlagen, über die ein Umschalten von einem Betriebsmodus in den wenigstens einen anderen Betriebsmodus über das Einstellen eines maximalen oder minimalen Schaltabstands und/oder einer maximalen oder minimalen Empfindlichkeit und die Auslösung eines Detektionsereignisses innerhalb eines über die Steuerelektronik der Sensoreinrichtung vorgegebenen Zeitraums steuerbar ist. Die Steuerelektronik einer erfindungsgemäßen Sensoreinrichtung ist mit anderen Worten eingerichtet, automatisch von einem Betriebsmodus in den wenigstens einen anderen Betriebsmodus um zu schalten, sofern innerhalb eines vorgegebenen Zeitraums festgestellt wird, dass nicht nur ein maximaler oder minimaler Schaltabstand bzw. eine maximale oder minimale Empfindlichkeit an der Sensoreinrichtung eingestellt wurde, sondern innerhalb dieses Zeitraums auch noch die Auslösung eines bestimmten Detektionsereignisses erfolgt ist. Wird das Vorliegen dieser beiden Bedingungen innerhalb des vorgegebenen Zeitraums elektronisch detektiert, kann von einem bewussten Bedienereignis zur Umschaltung in einen anderen Betriebsmodus ausgegangen werden.

Grundgedanke der Erfindung ist hierbei insbesondere, die Möglichkeit zur Einstellung eines Schaltabstands und/oder der Empfindlichkeit zu nutzen, um hierüber auch ein bewusstes Bedienereignis zum Umschalten in einen anderen Betriebsmodus zu erzeugen, sofern weitere Kriterien erfüllt sind. Hierdurch lässt sich das Umschalten in einen anderen Betriebsmodus steuern, ohne dass hierfür an der Sensoreinrichtung zusätzliche Bedien- und/oder Schalterelemente vorgesehen werden müssen. Es werden vielmehr lediglich Funktionen genutzt, die die Sensoreinrichtung ohnehin aufweist, die aber durch ihre Nutzung in einer bestimmten Reihenfolge und innerhalb eines vorgegebenen Zeitraums als Bedienereignis zum Umschalten in einen anderen Betriebsmodus gewertet werden.

In den wenigstens zwei unterschiedlichen Betriebsmodi können beispielsweise unterschiedliche Betriebsparameter für die Überwachung des Sensorbereichs in der Steuerelektronik der Sensoreinrichtung genutzt sein und/oder die Abmessungen und/oder die räumliche Lage des Sensorbereichs verschieden sein. Je nach Betriebsmodus kann hierbei z.B. insbesondere vorgesehen sein, dass mindestens ein Betriebsparameter in einer Auswertelogik der Steuerelektronik für die Detektion eines Detektionsereignisses in einem Betriebsmodus berücksichtigt wird, in einem anderen Betriebsmodus aber nicht oder sogar dessen Erfassung deaktiviert ist. Durch die sich je nach Betriebsmodus unterscheidenden Betriebsparameter kann beispielsweise die Empfindlichkeit der Sensoreinrichtung unterschiedlich eingestellt sein.

Alternativ oder ergänzend kann je nach Betriebsmodus eine unterschiedliche Anzahl an ausgewerteten Messwerten für eine Mittelwertbildung und/oder für die Berechnung einer von der Steuerelektronik genutzten Zeitkonstante herangezogen werden. So kann in einem Betriebsmodus, in dem eine erhöhte Anzahl von Messwerten genutzt wird, die elektromagnetische Verträglichkeit (EMV) verbessert sein. In einem hierauf basierenden Ausführungsbeispiel ist beispielsweise je nach Betriebsmodus eine unterschiedliche Schaltfrequenz gewählt. Über eine erhöhte Anzahl von Werten für die Mittelwertbildung ist hierbei dann die Schaltfrequenz der Sensoreinrichtung verringert, wodurch jedoch die EMV und die Stabilität der Messergebnisse verbessert sind.

In einer Ausführungsvariante ist je nach Betriebsmodus ein Filter der Sensoreinrichtung aktiviert oder deaktiviert oder mit unterschiedlichen Parametern betrieben. Ein solches Filter kann hierbei mathematisch oder schaltungstechnisch (z.B. über ein RC-Glied) gebildet sein. Über die erfindungsgemäße Lösung kann somit beispielsweise ein elektronisches Filter softwareseitig und/oder hardwareseitig schaltbar sein, ohne hierfür ein Bedien- oder Schalterelement - zusätzlich zu dem für die Einstellung eines Schaltabstands vorgesehenen Bedienelements - betätigen zu müssen.

In den unterschiedlichen Betriebsmodi kann auch, wie bereits einleitend erläutert, zwischen einer Öffner- und Schließerfunktion umgeschaltet werden. Bei einer Sensoreinrichtung mit wenigstens einem optischen Sensorelement (z.B. einer Gabellichtschranke) kann hierunter die Umschaltung auf eine High- oder Low-Power-Variante fallen, d.h., einen Betriebsmodus, bei dem die Sendeleistung verändert ist, um die Schmutzunempfindlichkeit der Sensoreinrichtung zu verbessern oder die Messempfindlichkeit zu verbessern. Insbesondere bei einer Sensoreinrichtung mit mindestens einem Ultraschallsensor kann je nach Betriebsmodi ein verschiedener Sensorbereich überwacht werden, d.h., zum Beispiel in einem ersten Betriebsmodus ein Nahfeld und in einem zweiten Betriebsmodus ein Fernfeld. Alternativ oder ergänzend kann sich in den Betriebsmodi unterscheiden, ob und in welchem Maß Umwelteinflüsse als Einflussgrößen für die Detektion eines Detektionsereignisses von der Steuerelektronik berücksichtigt werden. Dies schließt insbesondere ein, dass je nach Betriebsmodus eine Temperaturkompensation ein- oder ausgeschaltet und/oder mit unterschiedlichen Parameter betrieben sein kann. Beispielsweise kann eine Temperaturkompensation mit oder ohne Messung einer Außentemperatur arbeiten.
Der Zeitraum, innerhalb dessen ein Einstellen eines maximalen oder minimalen Schaltabstands und die vorhergehende oder nachfolgende Auslösung eines Detektionsereignisses zu einem automatischen Umschalten von einem Betriebsmodus in einen anderen Betriebsmodus führt, kann sich grundsätzlich darauf beziehen, dass innerhalb eines definierten Zeitfensters wenigstens beide Bedingungen (einerseits Einstellen eines maximalen oder minimalen Schaltabstands und/oder einer maximalen oder minimalen Empfindlichkeit und andererseits Auslösung eines bestimmten Detektionsereignisses) erfüllt sein müssen oder dass innerhalb eines definierten Zeitfensters nach dem Erfüllen der ersten Bedingung (z.B. Einstellung eines maximalen oder minimalen Schaltabstands / Einstellung einer maximalen oder minimalen Empfindlichkeit) wenigstens die zweite Bedingung (Auslösung eines bestimmten Detektionsereignisses) erfüllt sein muss. In einer Ausführungsvariante ist der Beginn des über die Steuerelektronik vorgegebenen Zeitraums durch ein Einschalten der Sensoreinrichtung vorgegeben.

Beim Einschalten der Sensoreinrichtung wird hierfür beispielsweise ein Aktivierungssignal erzeugt, das einen Zeitgeber der Steuerelektronik aktiviert. Hierbei wird dann vorzugsweise überwacht, ob innerhalb eines vorgegebenen Zeitraums nach dem Einschalten der Sensoreinrichtung nicht nur das Einstellen eines maximalen oder minimalen Schaltabstands und/oder einer maximalen oder minimalen Empfindlichkeit, sondern auch eine anschließende, gezielte Auslösung eines Detektionsereignisses erfolgt. Folglich wird hier eine Auswertung vorgenommen, ob durch ein Einstellen eines maximalen oder minimalen Schaltabstands und/oder einer maximalen oder minimalen Empfindlichkeit und durch eine anschließende gezielte Auslösung eines Detektionsereignisses durch einen Nutzer nach dem Einschalten der Sensoreinrichtung ein Umschalten in einen anderen Betriebsmodus getriggert werden soll. Innerhalb des vorgegebenen Zeitraums nach dem Einschalten der Sensoreinrichtung, zum Beispiel innerhalb von weniger als 6, insbesondere innerhalb von 5 Minuten nach dem Einschalten wird somit das Einstellen eines maximalen oder minimalen Schaltabstands und/oder einer maximalen oder minimalen Empfindlichkeit und eine anschließende Auslösung eines Detektionseignisses durch eine Auswertelogik der Steuerelektronik als Bedienereignis zum Wechseln in einen anderen Betriebsmodus gewertet.

Die Steuerelektronik weist in einer Ausführungsvariante eine Auswertelogik auf, die ein Umschalten in einen anderen Betriebsmodus nur auslöst, wenn das nach dem Einstellen eines maximalen oder minimalen Schaltabstands und/oder einer maximalen oder minimalen Empfindlichkeit ausgelöste Detektionsereignis mindestens über eine in der Steuerelektronik hinterlegte Detektionsdauer hinweg detektiert wird. In dieser Variante reicht es folglich nicht aus, wenn nur kurzzeitig ein Detektionsereignis festgestellt wird. Zur Vermeidung von etwaigen Fehlauslösungen ist es hier vielmehr erforderlich, dass ein weiteres Kriterium vor dem Umschalten in einen anderen Betriebsmodus erfüllt ist, nämlich dass zum Beispiel ein Objekt über eine definierte Zeitdauer, beispielsweise mehr als 3, 6 oder 10 Sekunden, im Sensorbereich vorliegt oder ein Objekt über eine definierte Zeitdauer, beispielsweise für mehr als 3, 6 oder 10 Sekunden, aus dem Sensorbereich entfernt wird.

Das mindestens eine Bedienelement kann beispielsweise ein Potentiometer sein. Gerade bei bisher bekannten Sensoreinrichtungen mit wenigstens einem Potentiometer, über das ein Schaltabstand und/oder eine Empfindlichkeit der Sensoreinrichtung einstellbar ist, wird die erfindungsgemäße Lösung als besonders vorteilhaft erachtet. So ist letztlich über das Potentiometer eine zusätzliche Funktionalität durch geschickte Auslegung einer Auswertelogik der Steuerelektronik bereitgestellt, sodass über das Potentiometer auch eine Umschaltung zwischen wenigstens zwei Betriebsmodi steuerbar ist, ohne hierfür ein zusätzliches Bedien- oder Schalterelement an der Sensoreinrichtung betätigen oder gar vorsehen zu müssen. Dabei kann vorgesehen sein, über einen maximalen Potentiometerwert einen minimalen oder maximalen Schaltabstand einzustellen.

In einer Ausführungsvariante ist das Bedienelement in einem Verstellbereich zwischen zwei Endpositionen verstellbar, um den Schaltabstand und/oder eine Empfindlichkeit der Sensoreinrichtung einzustellen. Hierbei führt in wenigstens einem Teilbereich vor Erreichen einer der Endpositionen eine Verstellung des Bedienelements zu keiner Veränderung des Schaltabstands und/oder der Empfindlichkeit mehr. Beispielsweise ist in einer hierauf basierenden Weiterbildung mit einem drehbaren Potentiometer als Bedienelement der Drehbereich des Potentiometers so ausgelegt, dass in einem letzten Bereich vor Erreichen einer Endposition eine Drehung des Potentiometers keine Empfindlichkeitsänderung mehr mit sich bringt. In einer solchen Variante kann nun vorgesehen sein, dass die Auswertelogik der Sensoreinrichtung eingerichtet ist, ein Umschalten in einer anderen Betriebsmodus nur auszulösen, wenn das Bedienelement bis in diese Endposition verstellt wurde. Das Umschalten in den anderen Betriebsmodus ist somit nicht nur davon abhängig, dass ein minimaler oder maximaler Schaltabstand und/oder eine maximale oder minimale Empfindlichkeit eingestellt wurde, was über das Vorliegen des Bedienelements in dem Teilbereich erreicht werden kann, sondern dass das Bedienelement tatsächlich bis in eine Endposition und damit auf Anschlag verstellt wird. Hierdurch wird die Wahrscheinlichkeit von Fehlauslösungen weiter minimiert, da ein Nutzer das Bedienelement nicht nur bis in den Teilbereich, sondern tatsächlich bis zu der jeweiligen Endposition verstellen muss, um ein Umschalten in einen anderen Betriebsmodus auszulösen.

Die erfindungsgemäße Lösung kann insbesondere bei Sensoreinrichtungen mit mindestens einem kapazitiven, optischen, induktiven und/oder magnetischen Sensorelement und/oder einem Ultraschallsensor zum Einsatz kommen, wobei mittels des jeweiligen Sensorelements oder des jeweiligen Sensors der Sensorbereich auf das Vorhandensein und/oder die Abwesenheit eines Objekts überwacht wird.

In einem Ausführungsbeispiel umfasst die Sensoreinrichtung einen Näherungsschalter und eine Auswertelogik, die eingerichtet ist, den Abstand eines Objekts in dem Sensorbereich zu dem Näherungsschalter auszuwerten. Diese Auswertelogik kann dann insbesondere eingerichtet sein, ein Umschalten in einen anderen Betriebsmodus nur auszulösen, sofern als Detektionsereignis das Vorhandensein eines Objekts in dem Sensorbereich detektiert wird und zusätzlich der Abstand dieses Objekts zu dem Näherungsschalter unter einem Schwellwert liegt. Hierbei kann ein Schwellwert für den Abstand oder zumindest für einen repräsentativen Messwert in der Steuerelektronik hinterlegt sein, sodass ein Vorhandensein eines Objekts in unmittelbarer Nähe des Näherungsschalters feststellbar ist und hierdurch in Kombination mit den vorgenannten anderen Bedingungen mit ausreichender Sicherheit auf ein bewusst ausgelöstes Bedienereignis oder eine Kette von Bedienereignissen zum Umschalten des Betriebsmodus geschlossen werden kann.

Beispielsweise umfasst die Sensoreinrichtung einen kapazitiven Näherungsschalter und die Auswertelogik ist eingerichtet, ein Umschalten in einen anderen Betriebsmodus nur auszulösen, sofern als Detektionsereignis das Vorhandensein eines Objekts in dem Sensorbereich detektiert wird und eine maximale Bedämpfung des kapazitiven Näherungsschalters festgestellt wird. Wird in diesem Zusammenhang zum Beispiel gefordert, dass ein maximaler Schaltabstand eingestellt und innerhalb eines definierten Zeitfensters dann eine maximale Bedämpfung des Näherungsschalters erfolgt, bevor ein Umschalten ausgelöst wird, ist bei normalem Betrieb nahezu ausgeschlossen, dass ein Umschalten unbeabsichtigt ausgelöst wird.

Basierend auf dem zuvor erläuterten Ausführungsbeispielen kann in einer Ausführungsvariante beispielsweise überprüft werden, ob eine Mehrzahl von Bedingungen erfüllt ist, bevor automatisch ein Umschalten in einen anderen Betriebsmodus erfolgt. So muss beispielsweise innerhalb eines definierten Zeitfensters nach dem Einschalten einer Sensoreinrichtung mit einem kapazitiven Näherungsschalter ein maximaler oder minimaler Schaltabstand eingestellt werden, bevor im Anschluss eine maximale Bedämpfung über mindestens eine Detektionsdauer, zum Beispiel von mehr als 3 oder 6 Sekunden erfolgt. Erst wenn alle diese Kriterien sukzessiv erfüllt wurden, erfolgt ein Wechsel in einen anderen Betriebsmodus und es wird zum Beispiel über analoge Schaltungsmaßnahmen oder einen Mikrocontroller der Sensoreinrichtung eine Funktionalität eines Schaltausgangs der Sensoreinrichtung von Öffner auf Schließer umgestellt oder umgekehrt. Praktisch wäre in der vorgenannten Variante somit nach dem Einschalten der Sensoreinrichtung die Möglichkeit für eine NO/NC-Umschaltung ("NO" für englisch "normally open", auf Deutsch "normalerweise offen"; "NC" für englisch "normally closed", auf Deutsch "normalerweise geschlossen") für zum Beispiel 5 Minuten möglich. Für das Umschalten dreht dann ein Nutzer des Weiteren innerhalb dieser 5 Minuten ein Potentiometer der Sensoreinrichtung auf maximalen oder minimalen Schaltabstand und hält kurz danach, zum Beispiel innerhalb von weniger als 10 Sekunden, seinen Finger vor oder an den kapazitiven Näherungsschalter, um für eine maximale Bedämpfung des Näherungsschalters zu sorgen. Hält der Nutzer seinen Finger mehr als 6 Sekunden vor oder an den Näherungsschalter und bleibt der Näherungsschalter hierüber maximal bedämpft, wird ein Umschalten in einen anderen Betriebsmodus ausgelöst. Hierbei signalisiert die Sensoreinrichtung beispielsweise über wenigstens ein Anzeigeelement visuell, zum Beispiel durch Blinken eines Leuchtmittels, die Umschaltung von NO zu NC oder NC zu NO und schaltet um. Die Sensoreinrichtung ist wieder in dem neuen Betriebsmodus betriebsbereit. Anschließend kann der Nutzer den gewünschten Schaltabstand durch Drehen des Potentiometers einstellen.

Ein weiterer Aspekt der Erfindung ist ein Verfahren zum Umschalten zwischen wenigstens zwei Betriebsmodi einer Sensoreinrichtung, ohne dass hierfür ein Schalterelement der Sensoreinrichtung gesondert zu betätigen ist oder zusätzlich zu einem Bedienelement für die Einstellung eines Schaltabstands und/oder einer Empfindlichkeit ein zusätzliches Bedienelement der Sensoreinrichtung betätigt werden muss.

Ein erfindungsgemäßes Verfahren zeichnet sich dabei durch wenigstens die folgenden Schritte aus:
- Bereitstellen einer Sensoreinrichtung zur Überwachung eines Sensorbereichs, wobei
   o über die Sensoreinrichtung das Vorhandensein eines Objekts in einem Sensorbereich und/oder die Abwesenheit eines Objekts in dem Sensorbereich als Detektionsereignis detektierbar ist,
   o ein Schaltabstand und/oder die Empfindlichkeit der Sensoreinrichtung zwischen einem Minimalwert und einem Maximalwert einstellbar ist, und
   o die Sensoreinrichtung in wenigstens zwei unterschiedlichen Betriebsmodi betreibbar ist;
- Einstellen eines maximalen oder minimalen Schaltabstands und/oder einer maximalen oder minimalen Empfindlichkeit an der Sensoreinrichtung und Auslösen eines Detektionsereignisses;
- automatisches Umschalten von einem Betriebsmodus in den wenigstens einen anderen Betriebsmodus, wenn einerseits das Einstellen eines maximalen oder minimalen Schaltabstands und/oder einer maximalen oder minimalen Empfindlichkeit und andererseits das Auslösen eines Detektionsereignisses innerhalb eines vorgegebenen Zeitraums erfolgt ist.

Ein erfindungsgemäßes Verfahren kann hierbei selbstverständlich bei einer erfindungsgemäß ausgestalteten Sensoreinrichtung zum Einsatz kommen. Demgemäß gelten vorstehend und nachstehend erläuterte Vorteile und Merkmale von Ausführungsvarianten einer erfindungsgemäßen Sensoreinrichtung auch für Ausführungsvarianten eines erfindungsgemäßen Verfahrens und umgekehrt.

Insbesondere kann im Rahmen einer Ausführungsvariante eines erfindungsgemäßen Verfahrens vorgesehen sein, dass
- der Beginn des vorgegebenen Zeitraums, innerhalb dessen über das Einstellen eines maximalen oder minimalen Schaltabstands und/oder einer maximalen oder minimalen Empfindlichkeit und der Auslösung eines Detektionsereignisses ein Umschalten in einen anderen Betriebsmodus auslösbar ist, durch ein Einschalten der Sensoreinrichtung vorgegeben wird, und/oder
- ein Umschalten in einen anderen Betriebsmodus nur auslöst wird, wenn das nach dem Einstellen eines maximalen oder minimalen Schaltabstands und/oder einer maximalen oder minimalen Empfindlichkeit ausgelöste Detektionsereignis mindestens über eine vorgegebene Detektionsdauer detektiert wird, und/oder
- die Sensoreinrichtung einen kapazitiven Näherungsschalter umfasst und ein Umschalten in einen anderen Betriebsmodus nur ausgelöst wird, sofern als Detektionsereignis das Vorhandensein eines Objekts in dem Sensorbereich detektiert wird und eine maximale Bedämpfung des kapazitiven Näherungsschalters festgestellt wird.

Weitere Vorteile und Merkmale der Erfindung werden bei der nachfolgenden Beschreibung von Ausführungsbeispielen anhand der Figuren deutlich werden.

Hierbei zeigen:
- Figur 1: eine erfindungsgemäße Sensoreinrichtung mit dem Finger eines Nutzers zum automatischen Umschalten des Näherungsschalters zwischen einer Öffner- und einer Schließerfunktion;
- Figur 2: ein Ablaufschema für die Veranschaulichung einer Ausführungsvariante eines erfindungsgemäßen Verfahrens, mit dem bei einer Sensoreinrichtung mit dem Näherungsschalter der Figur 1 zwischen einer Öffner- und einer Schließerfunktion lediglich unter Nutzung eines Potentiometers und mithilfe einer maximalen Bedämpfung des Näherungsschalters umgeschaltet werden kann.

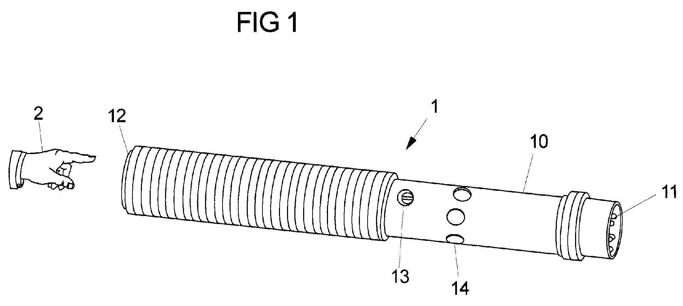

Die Figur 1 zeigt in perspektivischer Ansicht eine Sensoreinrichtung mit einem Näherungsschalter 1, der ein kreiszylindrisches Gehäuse 10 umfasst. Der Näherungsschalter 1 ist über ein an dem Gehäuse 10 vorgesehenes Außengewinde an einer Halterung einschraubbar, die zum Beispiel dem Näherungsschalter eine bestimmte Position innerhalb einer Werkzeugmaschine vorgibt. An einer ersten Stirnseite des Gehäuses 10 weist der Näherungsschalter 1 einen Anschlussbereich 11 auf. An diesem Anschlussbereich 11 sind Signalleitungen anschließbar, um Signale des Sensors auslesen zu können. An dem anderen, zweiten stirnseitigen Ende des Gehäuses 10 ist ein Sensorabschnitt 12 vorgesehen. An diesem Sensorabschnitt 12 beginnt ein durch den vorliegend kapazitiven Näherungsschalter 1 definierter Sensorbereich, der in an sich bekannter Weise auf das Vorhandensein und/oder die Abwesenheit eines Objekts überwacht werden kann. Dabei ist eine Auswertelogik des Näherungsschalters 1 eingerichtet, über den Grad der Bedämpfung auch einen Abstand eines Objekts von dem Näherungsschalter 1 auszuwerten bzw. auf diesen Abstand zu schließen.

Der Näherungsschalter weist auch ein Bedienelement in Form eines Potentiometers 13 auf. Dieses ist an der Außenseite des Gehäuses 10 teilweise zugänglich, sodass durch Drehung eines Bedienteils des Potentiometers 13 ein Schaltabstand und damit eine Reichweite des Näherungsschalters 1 vorzugsweise stufenlos eingestellt werden kann.

Über an der Außenseite des Gehäuses 10 sichtbare Anzeigeelemente 14 ist eine für einen Nutzer visuell wahrnehmbare Anzeige eines (Aktivitäts-) Status des Näherungsschalters 1 bereitgestellt. Je nach Betriebszustand (an/aus) des Näherungsschalters 1 kann hier beispielsweise ein Anzeigeelement 14 in einer bestimmten Farbe leuchten. Über die Anzeigeelemente 14 kann zudem der aktuell eingestellte Betriebsmodus angezeigt werden, wenn wie vorliegend der Näherungsschalter 1 in wenigstens zwei unterschiedlichen Betriebsmodi betreibbar ist.

Hierbei werden unter zwei verschiedenen Betriebsmodi insbesondere solche Betriebsmodi des Näherungsschalters 1 verstanden, bei denen ein Schaltausgang des Näherungsschalters 1 entweder als Öffner oder Schließer betrieben wird. Der Näherungsschalter 1 erzeugt somit ein Sensorsignal entweder, wenn ein Objekt aus dem bewachten Sensorbereich entfernt oder zumindest ausreichend weit von dem Näherungsschalter 1 entfernt ist (NC-Betrieb), oder, wenn ein Objekt in dem überwachten Sensorbereich vorhanden ist oder sich zumindest dem Näherungsschalter 1 ausreichend genährt hat (NO-Betrieb).

Um zwischen den einzelnen Betriebsmodi umschalten zu können, sieht der vorliegende Näherungsschalter 1 keine zusätzliche Bedienelemente oder Schalter, wie zum Beispiel eine Teach-in-Taste vor. Vielmehr wird das Umschalten zwischen den einzelnen Betriebsmodi über eine Auswertelogik des Näherungsschalters 1 und mithilfe des Potentiometers 13 gesteuert. Dabei ist beim Einschalten des Näherungsschalters 1 ein definierter Zeitraum, von zum Beispiel 5 Minuten, vorgesehen, innerhalb dessen eine bestimmte Reihenfolge von Aktionen an dem Näherungsschalter 1 als Bedienereignis zum Umschalten und Wechseln der Betriebsmodi bewertet wird. Innerhalb des definierten Zeitraums nach dem Einschalten des Näherungsschalters 1 muss das Potentiometer 13 z.B. auf einen maximalen Schaltabstand eingestellt werden und anschließend der Näherungsschalter 1 maximal bedämpft werden. Für die maximale Bedämpfung hält ein Nutzer einen Finger seiner Hand 2 auf den Sensorabschnitt 12 oder eine hieran vorgesehene Kappe des Näherungsschalters 1. Hält diese maximale Bedämpfung im Anschluss an die Einstellung eines maximalen Schaltabstands innerhalb des vorgegebenen Zeitraums nach dem Einschalten für mindestens eine Detektionsdauer von mehr als 6 Sekunden an, wird der Steuerelektronik des Näherungsschalters 1 hierüber signalisiert, dass ein Umschalten in einen anderen Betriebsmodus erfolgen soll. Die Umschaltung des Schaltausgangs des Näherungsschalters 1 erfolgt hierbei zum Beispiel über analoge Schaltungsmaßnahmen oder einen Mikrocontroller des Näherungsschalters 1, der innerhalb des Gehäuses 10 untergebracht ist. Durch die Abfrage mindestens dreier Kriterien, die hier erfüllt sein müssen, bevor eine gewünschte Umschaltung eines Betriebsmodus erfolgt, können Fehlauslösungen nahezu ausgeschlossen werden.

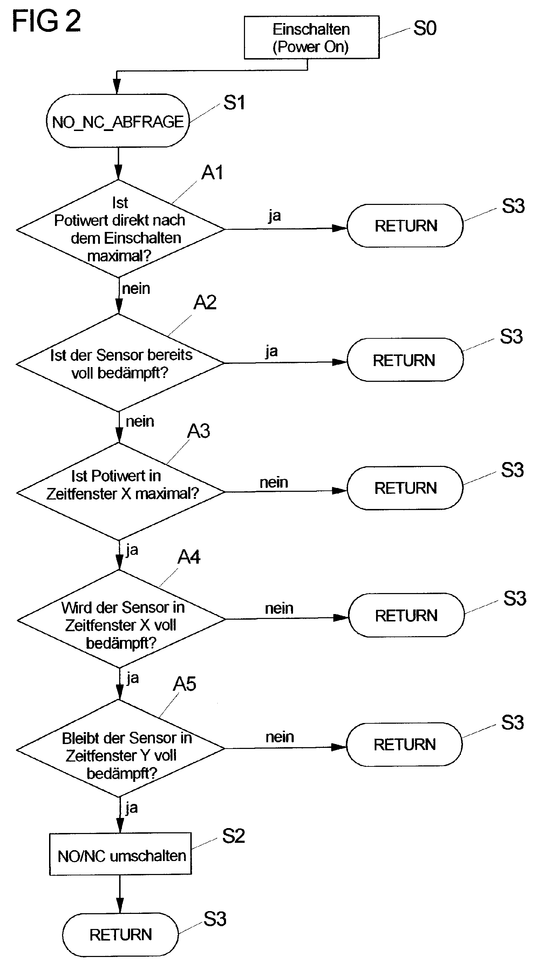

Die Figur 2 zeigt ein mögliches Ablaufdiagramm für eine automatische Umschaltung und dabei durchgeführte Abfragen A1 bis A5.

Zunächst wird in einem ersten Verfahrensschritt S0 der Näherungsschalter 1 eingeschaltet und damit ein Aktivierungssignal an die Auswertelogik der Steuerelektronik gesendet. In einem darauffolgenden Verfahrensschritt S1 wird eine "NO_NC_Abfrage" gestartet, um zu ermitteln, ob innerhalb des vorgegebenen Zeitfensters von 5 Minuten nach dem Einschalten die weiteren oben genannten Kriterien erfüllt sind und damit ein umschalten des Schaltungsausgangs erfolgen soll oder nicht.

Hierfür wird zunächst über eine Abfrage A1 geprüft, ob der Potiwert direkt nach dem Einschalten maximal ist, also bereits ein maximaler (oder minimaler) Schaltabstand beim Einschalten des Näherungsschalters 1 eingestellt war. War dies der Fall, startet in einem Schritt S3 der normale Betrieb des Näherungsschalters 1. Eine weitergehende Abfrage des Vorliegens der weiteren Kriterien wird nicht durchgeführt.

Wird demgegenüber aber festgestellt, dass ein maximaler (oder minimaler) Schaltabstand noch nicht eingestellt ist, wird in einer nachfolgenden Abfrage A2 geprüft, ob der Sensor bzw. Näherungsschalter 1 bereits voll bedämpft ist. Wird dies bejaht, wird ebenfalls direkt zum normalen Betrieb übergegangen.

Wird aber bei der Abfrage A2 festgestellt, dass zum Einschaltzeitpunkt keine volle Bedämpfung vorlag, erfolgt in einem nachfolgenden Abfrageschritt A3 die weitere Prüfung, ob innerhalb des vorgegebenen Zeitraums ("Zeitfenster X"), zum Beispiel von 5 Minuten nach dem Einschalten des Näherungsschalters 1, das Potentiometer 13 auf Anschlag zur Einstellung eines maximalen (oder minimalen) Schaltabstands betätigt wird. Nur wenn dies innerhalb des definierten Zeitraums erfolgt, prüft die Auswertelogik des Näherungsschalters 1, ob dann auch noch innerhalb des Zeitfensters eine volle Bedämpfung des Näherungsschalters 1 erfolgt (Verfahrensschritt A4).

Die volle Bedämpfung muss dabei mindestens über eine Detektionsdauer ("Zeitfenster Y") aufrechterhalten werden, sodass die Auswertelogik in einem späteren Abfrageschritt A5 für eben diese Detektionsdauer auch das Vorliegen dieses weiteren Kriteriums bejaht und eine Umschaltung des Betriebsmodus in einem Verfahrensschritt S2 auslöst, bevor dann der Näherungsschalter 1 wieder betriebsbereit ist und ein Schaltabstand über das Potentiometer 13 (neu) eingestellt werden kann.

Obwohl in den Figuren lediglich ein kapazitiver Näherungsschalter 1 und ein diesbezügliches Verfahren zum Umschalten zwischen zwei Betriebsmodi dargestellt ist, bei denen durch den Wechsel der Betriebsmodi ein Wechsel zwischen einer Schließer-und einer Öffner-Funktion ermöglicht ist, ist die erfindungsgemäße Lösung letztendlich nicht hierauf beschränkt. Beispielsweise kann im Rahmen der erfindungsgemäßen Lösung eine Umschaltung zwischen zwei Betriebsmodi vorgesehen sein, bei denen andere Betriebsparameter verschieden sind und/oder die Abmessungen und/oder die räumliche Lage eines überwachten Sensorbereichs variieren. Beispielsweise kann hierüber (a) eine Umschaltung auf eine High- oder Low-Power-Variante bei einem optischen Sensor (wie z.B. einer Gabellichtschranke), (b) eine Änderung eines Messbereichs zwischen Nah- und Fernfeld bei einem Ultraschallsensor, (c) eine Verbesserung der elektromagnetischen Verträglichkeit durch Erhöhung der Anzahl der Werte für eine Mittelwertbildung bzw. für die Berechnung einer Zeitkonstante oder (d) eine Umschaltung eines Schaltausgangs von einem digitalen auf ein analoges Schaltsignal vorgesehen sein.

### Bezugszeichenliste

- 1: Näherungsschalter (Sensoreinrichtung)
- 10: Gehäuse
- 11: Anschlussbereich
- 12: Sensorabschnitt
- 13: Potentiometer (Bedienelement)
- 14: Anzeigeelemente
- 2: Hand
- A1 - A7: Abfrage
- S0 - S3: Verfahrensschritt mit Signalisierung an oder durch Steuerelektronik

## Patentansprüche

1. Sensoreinrichtung zur Überwachung eines Sensorbereichs, wobei über die Sensoreinrichtung (1) das Vorhandensein und/oder die Abwesenheit eines Objekts (2) in dem Sensorbereich als Detektionsereignis detektierbar ist, und wobei
- die Sensoreinrichtung (1) mindestens ein Bedienelement (13) aufweist, über das ein Schaltabstand und/oder eine Empfindlichkeit der Sensoreinrichtung (1) zwischen einem Minimalwert und einem Maximalwert einstellbar ist, und
- die Sensoreinrichtung (1) in wenigstens zwei unterschiedlichen Betriebsmodi betreibbar ist,
**gekennzeichnet durch**
eine Steuerelektronik, über die ein Umschalten von einem Betriebsmodus in den wenigstens einen anderen Betriebsmodus über
- das Einstellen eines maximalen oder minimalen Schaltabstands und/oder einer maximalen oder minimalen Empfindlichkeit und
- die Auslösung eines Detektionsereignisses
innerhalb eines über die Steuerelektronik der Sensoreinrichtung (1) vorgegebenen Zeitraums steuerbar ist.

2. Sensoreinrichtung nach Anspruch 1, **dadurch gekennzeichnet, dass** in den wenigstens zwei unterschiedlichen Betriebsmodi unterschiedliche Betriebsparameter für die Überwachung des Sensorbereichs in der Steuerelektronik der Sensoreinrichtung genutzt sind und/oder die Abmessungen und/oder die räumliche Lage des Sensorbereichs verschieden sind.

3. Sensoreinrichtung nach Anspruch 1 oder 2, **dadurch gekennzeichnet, dass.** der Beginn des über die Steuerelektronik vorgegebenen Zeitraums, innerhalb dessen über das Einstellen eines maximalen oder minimalen Schaltabstands und/oder einer maximalen oder minimalen Empfindlichkeit und der Auslösung eines Detektionsereignisses ein Umschalten in einen anderen Betriebsmodus auslösbar ist, durch ein Einschalten der Sensoreinrichtung (1) vorgegeben ist.

4. Sensoreinrichtung nach einem der Ansprüche 1 bis 3, **dadurch gekennzeichnet, dass** die Steuerelektronik eine Auswertelogik aufweist, die ein Umschalten in einen anderen Betriebsmodus nur auslöst, wenn das nach dem Einstellen eines maximalen oder minimalen Schaltabstands und/oder einer maximalen oder minimalen Empfindlichkeit ausgelöste Detektionsereignis mindestens über eine in der Steuerelektronik hinterlegte Detektionsdauer detektiert wird.

5. Sensoreinrichtung nach einem der vorhergehenden Ansprüche, **dadurch gekennzeichnet, dass** das mindestens eine Bedienelement ein Potentiometer (13) umfasst.

6. Sensoreinrichtung nach einem der vorhergehenden Ansprüche, **dadurch gekennzeichnet, dass** das Bedienelement (13) in einem Verstellbereich zwischen zwei Endpositionen verstellbar ist, um den Schaltabstand und/oder die Empfindlichkeit einzustellen, und in wenigstens einem Teilbereich vor Erreichen einer der Endpositionen eine Verstellung des Bedienelements (13) zu keiner Veränderung des Schaltabstands und/oder der Empfindlichkeit mehr führt, wobei die Auswertelogik eingerichtet ist, ein Umschalten in einen anderen Betriebsmodus nur auszulösen, wenn das Bedienelement bis in diese Endposition verstellt wurde.

7. Sensoreinrichtung nach einem der vorhergehenden Ansprüche, **dadurch gekennzeichnet, dass** die Sensoreinrichtung (1) mindestens ein kapazitives, optisches, induktives und/oder magnetisches Sensorelement und/oder einen Ultraschallsensor aufweist, um den Sensorbereich zu überwachen.

8. Sensoreinrichtung nach einem der vorhergehenden Ansprüche, **dadurch gekennzeichnet, dass** die Sensoreinrichtung einen Näherungsschalter (1) umfasst und eine Auswertelogik der Steuerelektronik eingerichtet ist, den Abstand eines Objekts (2) in dem Sensorbereich zu dem Näherungsschalter (1) auszuwerten.

9. Sensoreinrichtung nach Anspruch 8, **dadurch gekennzeichnet, dass** die Auswertelogik eingerichtet ist, ein Umschalten in einen anderen Betriebsmodus nur auszulösen, sofern als Detektionsereignis das Vorhandensein eines Objekts (2) in dem Sensorbereich detektiert wird und zusätzlich der Abstand dieses Objekts (2) zu dem Näherungsschalter unter einem Schwellwert liegt.

10. Sensoreinrichtung nach dem Anspruch 7 und dem Anspruch 9, **dadurch gekennzeichnet, dass** die Sensoreinrichtung einen kapazitiven Näherungsschalter (1) umfasst und die Auswertelogik eingerichtet ist, ein Umschalten in einen anderen Betriebsmodus nur auszulösen, sofern als Detektionsereignis das Vorhandensein eines Objekts (2) in dem Sensorbereich detektiert wird und eine maximale Bedämpfung des kapazitiven Näherungsschalters (1) festgestellt wird.

11. Verfahren zum Umschalten zwischen wenigstens zwei Betriebsmodi einer Sensoreinrichtung (1), insbesondere einer Sensoreinrichtung (1) nach einem der Ansprüche 1 bis 10, mit wenigstens den folgenden Schritten:
- Bereitstellen einer Sensoreinrichtung zur Überwachung eines Sensorbereichs, wobei
o über die Sensoreinrichtung (1) das Vorhandensein und/oder die Abwesenheit eines Objekts (2) in dem Sensorbereich als Detektionsereignis detektierbar ist,
o ein Schaltabstand und/oder eine Empfindlichkeit der Sensoreinrichtung (1) zwischen einem Minimalwert und einem Maximalwert einstellbar ist, und
o die Sensoreinrichtung (1) in wenigstens zwei unterschiedlichen Betriebsmodi betreibbar ist,
- Einstellen eines maximalen oder minimalen Schaltabstands und/oder einer maximalen oder minimalen Empfindlichkeit an der Sensoreinrichtung (1) und Auslösen eines Detektionsereignisses,
- Automatisches Umschalten von einem Betriebsmodus in den wenigstens einen anderen Betriebsmodus, wenn das Einstellen eines maximalen oder minimalen Schaltabstands oder einer maximalen oder minimalen Empfindlichkeit und das Auslösen eines Detektionsereignisses innerhalb eines vorgegebenen Zeitraums erfolgt ist.

12. Verfahren nach Anspruch 11, **dadurch gekennzeichnet, dass**
- der Beginn des vorgegebenen Zeitraums, innerhalb dessen über das Einstellen eines maximalen oder minimalen Schaltabstands und/oder einer maximalen oder minimalen Empfindlichkeit und der Auslösung eines Detektionsereignisses ein Umschalten in einen anderen Betriebsmodus auslösbar ist, durch ein Einschalten der Sensoreinrichtung (1) vorgegeben wird, und/oder
- ein Umschalten in einen anderen Betriebsmodus nur auslöst wird, wenn das nach dem Einstellen eines maximalen oder minimalen Schaltabstands und/oder einer maximalen oder minimalen Empfindlichkeit ausgelöste Detektionsereignis mindestens über eine vorgegebene Detektionsdauer detektiert wird, und/oder
- die Sensoreinrichtung einen kapazitiven Näherungsschalter (1) umfasst und ein Umschalten in einen anderen Betriebsmodus nur ausgelöst wird, sofern als Detektionsereignis das Vorhandensein eines Objekts (2) in dem Sensorbereich detektiert wird und eine maximale Bedämpfung des kapazitiven Näherungsschalters (1) festgestellt wird.
